# EUROPÄISCHE PATENTSCHRIFT

(11) **EP 3 659 410 B1**
(45) Veröffentlichungstag und Bekanntmachung des Hinweises auf die Patenterteilung: **11.08.2021**
(21) Anmeldenummer: 18732721.8
(22) Anmeldetag: 14.06.2018
(51) Int. Cl.: H05K 5/00, F16H 61/00

(54) **ELEKTRISCHE BAUGRUPPE**
ELECTRICAL ASSEMBLY
ENSEMBLE ÉLECTRIQUE

(30) Priorität: 26.07.2017 DE 102017212796
(43) Veröffentlichungstag der Anmeldung: 03.06.2020
(73) Patentinhaber: Robert Bosch GmbH, 70442 Stuttgart (DE)
(72) Erfinder: SIPPEL, Bernd-Guenter, 71701 Schwieberdingen (DE); ZWEIGLE, Peter, 71254 Ditzingen (DE); DERINGER, Helmut, 74391 Erligheim (DE); ZELENY, Franco, 74354 Besigheim (DE); KATZENWADEL, Uwe, 71739 Oberriexingen (DE); HOFFMANN, Jens, 70376 Stuttgart (DE)
(86) Internationale Anmeldenummer: PCT/EP2018/065890
(87) Internationale Veröffentlichungsnummer: WO 2019/020272

(56) Entgegenhaltungen:
- DE-A1-102011 085 629
- DE-A1-102014 102 539
- DE-A1-102014 217 923
- DE-A1-102015 219 076
- JP-A- 2011 144 823
- JP-A- 2013 002 523

## Beschreibung

### Stand der Technik

In der Kraftfahrzeugtechnik werden Elektronikmodule zur Ansteuerung eines Getriebes am oder im Getriebe verbaut. Die Elektronikmodule können beispielsweise als Getriebesteuermodule ausgelegt sein und außer einer auf einer Leiterplatte angeordneten Steuerschaltung beispielsweise zusätzlich noch Steckerteile, Sensoren und Kontaktierungsschnittstellen zu Aktuatoren aufweisen. Derartige Elektronikmodule weisen elektrische Baugruppen auf, die in einem ölgefüllten Getriebeinnenraum verbaut werden müssen. Beispielsweise muss die elektronische Steuerschaltung vor dem aggressiven Getriebefluid geschützt werden. Zu diesem Zweck werden auch Vergussmassen eingesetzt, die auf die Leiterplatte zum Schutz der elektronischen Steuerschaltung aufgebracht wird. Beispielsweise ist aus der der DE 10 2011 085 629 A1 ein elektronisches Getriebesteuermodul bekannt, das ein metallisches Bechergehäuse und einen in dem Bechergehäuse angeordneten, mit elektronischen Bauelementen bestückten Schaltungsträger aufweist. Der Schaltungsträger ist zum Schutz vor dem aggressiven Getriebefluid und darin enthaltenen Metallspänen in dem Bechergehäuse mit einer Vergussmasse vergossen. Kontaktelemente ragen aus der Vergussmasse heraus und dienen teilweise zum Anschluss an die Spannungsversorgung, an einen EC-Motor, an Sensoren und/oder einen LIN- oder CAN-Bus.

### Offenbarung der Erfindung

Die Erfindung betrifft eine elektrische Baugruppe, insbesondere für den Einbau in oder an einem Kraftfahrzeuggetriebe, mit einer Leiterplatte mit wenigstens einer Bestückungsseite, wenigstens zwei auf der Bestückungsseite angeordneten Kontaktflächen, mit wenigstens zwei Kontaktelementen, die jeweils mit einem leiterplattenseitigen ersten Endabschnitt mit einer der Kontaktflächen elektrisch verbunden sind, und mit einer auf der Bestückungsseite der Leiterplatte angeordneten Vergussmasse, in welche die Kontaktelemente eingebettet sind, wobei die Vergussmasse mit den Kontaktflächen und leiterplattenseitigen Endabschnitte der Kontaktelemente in direktem Kontakt steht und diese abdeckt und wobei die Kontaktelemente mit von der Leiterplatte abgewandten zweiten Endabschnitten aus der Vergussmasse hervorstehen.

Erfindungsgemäß wird vorgeschlagen, einen Spanschutzrahmen an der elektrischen Baugruppe vorzusehen, der mit einem der Leiterplatte zugewandten Abschnitt an der Bestückungsseite der Leiterplatte angeordnet ist und der mit einem von der Leiterplatte abgewandten Abschnitt aus der Vergussmasse nach außen hervorsteht, wobei der aus der Vergussmasse nach außen hervorstehende Abschnitt des Spanschutzrahmens mehrere den Kontaktelementen jeweils zugeordnete, nicht mit Vergussmasse gefüllte Kontaktkammern bildet und in jeder Kontaktkammer jeweils nur ein zweiter Endabschnitt eines Kontaktelementes angeordnet ist.

### Vorteile der Erfindung

Vorteilhaft wird durch die hier vorgestellte elektrische Baugruppe ein wirksamer Schutz der elektrischen Kontaktierung zwischen einer Leiterplatte und auf der Leiterplatte angeordneten elektrischen Bauelementen beispielsweise vor aggressiven Getriebefluid und den darin enthaltenen Metallspänen erreicht. Die elektrischen Verbindungsmittel, beziehungsweise Kontaktelemente zwischen der Leiterplatte und einem elektrischen Bauelement, wie beispielsweise einem Sensorelement, können flexibel gestaltete Bereiche aufweisen, die zur Beibehaltung der erforderlichen Elastizität oder Beweglichkeit nicht vollständig in Vergussmasse eingebettet werden können, da sonst eine dauerhafte elektrische Kontaktierung beispielsweise bei Temperaturschwankungen nicht gewährleistet ist. Daher ist es notwendig, dass die Kontaktelemente von der Leiterplatte abgewandte zweite Endabschnitte aufweisen, die aus der Vergussmasse hervorstehen. In diesen aus der Vergussmasse hervorstehenden Endabschnitten liegen zwangsläufig die elektrischen Leiter von verschiedenen Anschlüssen mit unterschiedlichen Potentialen frei. Mittels der erfindungsgemäßen Lösung wird ein elektrischer Kurzschluss zwischen diesen Endabschnitten, der durch Metallspäne im Getriebeöl oder leitende Reaktionsprodukte entstehen könnte, vorteilhaft vermieden.

Dadurch, dass der aus der Vergussmasse nach außen hervorstehende Abschnitt des Spanschutzrahmens mehrere den Kontaktelementen jeweils zugeordnete, nicht mit Vergussmasse gefüllte Kontaktkammern bildet und in jeder Kontaktkammer jeweils nur ein zweiter Endabschnitt eines Kontaktelementes angeordnet ist, wird ein wirksamer Schutz dieses zweiten Endabschnittes erreicht. Ist ein elektrisches Bauelement an der Leiterplatte montiert, dass an seiner der Leiterplatte zuweisenden Seite wenigstens zwei Gegenkontakte aufweist, die mit den zweiten Enden der Kontaktelemente jeweils kontaktiert sind, können Metallspäne nur parallel zur Leiterplattenoberfläche in Richtung der Kontaktelement vordringen, da der untere Bereich durch die Einbettung der ersten Enden der Kontaktelemente in die Vergussmasse geschützt ist und auf der gegenüberliegenden Seite das montierte elektrische Bauelement einen gewissen Schutz darstellt. Die durch den Spanschutzrahmen oberhalb der Vergussmasse gebildeten Kontaktkammern stellen nun einen wirksamen Schutz gegen diese parallel zur Leiterplattenoberfläche in Richtung der Kontaktelement vordringen Metallspäne und anderen aggressive Substanzen dar.

Vorteilhafte Ausgestaltungen und Weiterbildungen der Erfindung werden durch die in den abhängigen Ansprüchen enthaltenen Merkmale ermöglicht.

Dadurch, dass das elektrische Bauelement in den aus der Vergussmasse nach außen hervorstehenden Abschnitt des Spanschutzrahmens eingreift, wird eine erste wirksame Schutzmaßnahme gegen vordringende Metallspäne gebildet. In dem verblieben Spalt zwischen dem elektrischen Bauelement und dem Spanschutzrahmen müssen die Metallspäne mehrfach die Richtung ändern, so dass ein einfaches geradliniges Vordringen und Durchspülen der Kontaktkammern in einer zur Leiterplattenoberfläche parallelen Richtung nicht möglich ist.

Vorteilhaft kann das elektrische Bauelement an seiner der Leiterplatte zuweisenden Seite eine Schutzgeometrie aus vorspringenden Wänden und/oder eingelassenen Nuten aufweisen, durch welche auch zwischen den Kontaktkammern ein wirksamer Schutz gegen wandernde Metallspäne gebildet wird.

Besonders vorteilhaft kann die Schutzgeometrie mit dem aus der Vergussmasse nach außen hervorstehenden Abschnitt des Spanschutzrahmens derart in einem labyrinthartigen Eingriff stehen, dass die Kontaktkammern fluidisch verbindende Zwischenräume zwischen der Schutzgeometrie und dem Spanschutzrahmen U-förmige Umlenkkanäle bilden.

In einer Ausführungsvariante der Erfindung kann die elektrische Baugruppe ein elektrisches Bauelement aufweisen, das einstückig mit dem Spanschutzrahmen ausgebildet ist. Insbesondere kann es sich hierbei um einen Kontaktschuh mit verstellbaren Einstellmitteln, an denen die Gegenkontakte ausgebildet sind, handeln. Vorteilhaft kann diese Ausführungsvariante für den Schutz von Hochstromanschlüssen von elektrischen Motoren verwandt werden, um die unterschiedlichen Potentiale der Kontaktelemente elektrisch voneinander zu trennen

Der Spanschutzrahmen kann in einfacher und preiswerte Weise aus Kunststoff, aus Metall oder aus einem Kunststoff-Metall-Verbund hergestellt werden.

Die elektrische Baugruppe ist besonders vorteilhaft einsetzbar als Teil eines elektronischen Getriebesteuermoduls oder Sensormoduls, das in oder an einem Kraftfahrzeuggetriebe verbaut wird.

### Kurze Beschreibung der Zeichnungen

Es zeigen:
Fig. 1 einen Teilausschnitt durch einen Querschnitt eines ersten Ausführungsbeispiels einer elektrischen Baugruppe,
Fig. 2 einen Teilausschnitt durch einen Querschnitt eines zweiten Ausführungsbeispiels einer elektrischen Baugruppe,
Fig. 3 einen Teilausschnitt durch einen Querschnitt eines dritten Ausführungsbeispiels einer elektrischen Baugruppe.

### Ausführungsformen der Erfindung

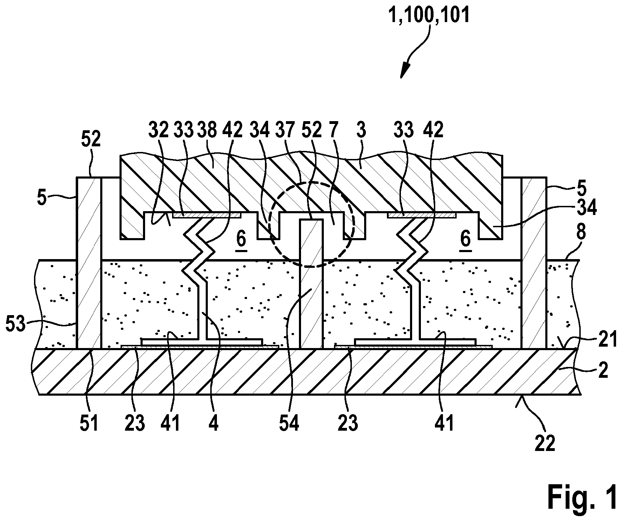

Fig. 1 zeigt einen Teilausschnitt durch einen Querschnitt eines ersten Ausführungsbeispiels einer elektrischen Baugruppe 1. Die Baugruppe 1 kann beispielsweise Teil eines elektronischen Steuermoduls 100, insbesondere eines Getriebesteuermoduls eines Kraftfahrzeuggetriebes oder beispielsweise Teil eines Sensormoduls 101 sein, das in oder an einem Kraftfahrzeuggetriebe verbaut wird und damit dem Getriebefluid ausgesetzt ist.

Die elektrische Baugruppe 1 umfasst eine Leiterplatte 2. Bei der Leiterplatte 2 kann es sich beispielsweise um eine konventionelle FR4-Leiterplatte aus glasfaserverstärktem Epoxidharz mit in einer oder mehreren Lagen angeordneten Kupferleiterbahnen handeln. Die Leiterplatte 2 weist eine als Bestückungsseite 21 vorgesehene erste Seite und eine davon abgewandte zweite Seite 22 auf. Auf der Bestückungsseite 21 sind Kontaktflächen 23 angeordnet, von denen in Fig. 1 zwei dargestellt sind. Die Kontaktflächen 21 können auf Kupfer bestehen und mittels der Leiterbahnen der Leiterplatte 2 mit nicht dargestellten Bauelementen der Leiterplatte 2, beispielsweise mit elektronischen Bauelementen einer elektronischen Steuerschaltung oder anderen Bauelementen verbunden sein. Auf jeder Kontaktfläche 23 ist jeweils ein metallisches Kontaktelement 4 angeordnet. Jedes Kontaktelement 4 weist einen leiterplattenseitigen ersten Endabschnitt 41 auf, der mit einer Montagefläche zur Auflage auf der zugeordneten Kontaktfläche 23 versehen ist. Die ersten Endabschnitte 41 können beispielsweise mit den Kontaktflächen 23 verlötet sein. Die Kontaktelemente 4 weisen weiterhin jeweils einen von dem ersten Endabschnitt abgewandten zweiten Endabschnitt 42 auf, der zur Kontaktierung eines elektrischen Bauelementes 3 dient. Die zweiten Endabschnitte 42 können, wie in Fig. 1 angedeutet ist, vorzugsweise federnd ausgestaltet sein.

Weiterhin umfasst die elektrische Baugruppe 1 einen Spanschutzrahmen 5. Der Spanschutzrahmen 5 kann aus Kunststoff oder Metall oder einem Kunststoff-Metall-Verbund bestehen. Der Spanschutzrahmen 5 weist einen äußeren umlaufenden Rahmen 53 auf, der durch Zwischenwände 54 in Kammern unterteilt ist. Der Spanschutzrahmen 5 ist mit einem der Leiterplatte 2 zugewandten Abschnitt 51 an der Bestückungsseite 21 der Leiterplatte 2 angeordnet. Eine Vorfixierung des Spanschutzrahmens 5 kann gegebenenfalls durch Warmverstemmen erfolgen.

Auf die Bestückungsseite 21 der Leiterplatte 2 ist eine Vergussmasse 8 aufgetragen. Dabei kann es sich um ein Duroplast, insbesondere ein Epoxidharz handeln. Die Vergussmasse 8 kann beispielsweise durch ein sogenanntes Damm-Fill-Verfahren aufgetragen werden. Dabei wird zunächst ein umlaufender Damm aus einem beispielsweise zähflüssigen Dammmaterial auf die Bestückungsseite 21 aufgetragen und anschließend die Vergussmasse 8 innerhalb des von dem Damm begrenzten Bereichs auf die Bestückungsseite 21 aufgebracht. Die Vergussmasse 8 kann dabei nicht dargestellte elektrische Bauelemente auf der Bestückungsseite 21 vollständig abdecken. Im Bereich des Spanschutzrahmens 5 wird die Vergussmasse 8 innerhalb des umlaufenden Rahmens 53 aufgetragen, was beispielsweise mit einer Dispensvorrichtung leicht durchgeführt werden kann. Dabei deckt die Vergussmasse 8 die ersten Endabschnitte 41 der Kontaktelemente 4 vollständig ab und füllt den Raum innerhalb des umlaufenden Rahmens 53 bis zu einer Füllhöhe, welche beispielsweise der Füllhöhe der Vergussmasse 8 außerhalb des Spanschutzrahmens 5 entsprechen kann. Der aus der Vergussmasse 8 nach außen hervorstehende Abschnitt 52 des Spanschutzrahmens 5 bildet in Fig. 1 beispielsweise zwei den beiden Kontaktelementen 4 jeweils zugeordnete, nicht mit Vergussmasse 8 gefüllte Kontaktkammern 6. Die Kontaktelemente 4 sind mit ihren ersten Endabschnitten 41 in direktem Kontakt zu der Vergussmasse 8 in diese eingebettet und stehen mit ihren von der Leiterplatte 2 abgewandten zweiten Endabschnitten 52 aus der Vergussmasse 8 nach außen hervor. Der aus der Vergussmasse 8 hervorstehende Bereich kann beispielsweise als Federelement ausgebildet sein. In jeder der beiden Kontaktkammer 6 ist jeweils nur ein zweiter Endabschnitt 42 eines Kontaktelementes 4 angeordnet. Es versteht sich, dass auch mehr als zwei Kontaktelemente 4 und mehr als zwei Kontaktkammern 6 vorhanden sein können. Ebenso können mehr als nur eine Trennwand 54 und auch sich kreuzende Trennwände vorgesehen sein. Der äußere umlaufende Rahmen 53 bildet zusammen mit allen darin angeordneten Trennwänden 54 für jedes Kontaktelement 4 jeweils eine Kontaktkammer 6, die den jeweiligen zweiten Endabschnitt 42 umlaufend umgibt und dadurch schützt. Durch die Vergussmasse 8 wird zudem der Spanschutzrahmen 5 an der Leiterplatte 2 mechanisch zuverlässig befestigt.

Wie in Fig. 1 weiterhin zu erkennen ist, greift ein elektrisches Bauelement 3 in den aus der Vergussmasse 8 nach außen hervorstehenden Abschnitt 52 des Spanschutzrahmens 5 ein. Das elektrische Bauelement 3 kann beispielsweise ein Sensorbauelement 38 sein. Das elektrische Bauelement 3 weist an seiner der Leiterplatte 3 zuweisenden Seite 32 wenigstens zwei Gegenkontakte 33 aufweist, die mit den zweiten Endabschnitten 42 der Kontaktelemente 4 jeweils kontaktiert sind. Dabei pressen sich die zweiten Endabschnitte 42 federnd an die jeweiligen Gegenkontakte 33 an. Das elektrische Bauelement 3 weist an seiner der Leiterplatte 2 zugewandten Seite 32 eine Schutzgeometrie 37 beispielsweise zwei vorspringenden Wänden 34 auf, zwischen denen eine mittlere Trennwand 54 des Spanschutzrahmens 5 mit Abstand eingreift. In Fig. 1 ist zu erkennen, dass die Schutzgeometrie 37 mit dem aus der Vergussmasse 8 nach außen hervorstehenden Abschnitt 52 des Spanschutzrahmens 5 derart in einem labyrinthartigen Eingriff steht, dass die Kontaktkammern 6 fluidisch verbindende Zwischenräume zwischen der Schutzgeometrie 37 und dem Spanschutzrahmen 5 U-förmige Umlenkkanäle 7 bilden, welche verhindern, dass in Fig. 1 beispielsweise ein Metallspan von der linken Kontaktkammer 6 in die rechte Kontaktkammer gelangen kann.

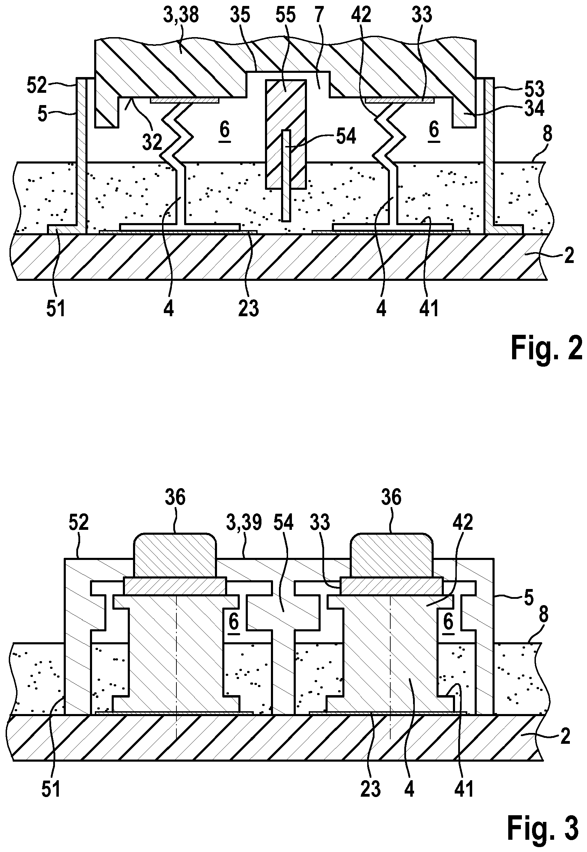

Fig. 2 zeigt ein zweites Ausführungsbeispiel, bei dem der Spanschutzrahmen 5 aus Metall gebildet ist. Eine Zwischenwand 54 ist zusätzlich mit einer Verdickung aus Kunststoff umspritzt. Das elektrische Bauelement 3 weist in diesem Ausführungsbeispiel an seiner der Leiterplatte 2 zugewandten Seite 32 eine Schutzgeometrie 37 aus beispielsweise einer eingelassenen Nut 35 auf, in welche die mittlere Trennwand 54 des Spanschutzrahmens 5 eingreift, so dass auch hier ein U-förmiger Umlenkkanal 7 gebildet wird.

Fig. 3 zeigt ein Ausführungsbeispiel mit einer abgewandelten Ausführungsform. Hier ist als elektrisches Bauelement 3 ein Kontaktschuh 39 an der Leiterplatte 2 angeordnet. Der Kontaktschuh 39 weist verstellbaren Einstellmitteln 36 auf, an denen die Gegenkontakte 33 ausgebildet sind. Die Einstellmittel 36 können beispielsweise Schrauben sein. Wie in Fig. 3 zu erkennen ist, ist das elektrische Bauelement 3 in diesem Ausführungsbeispiels einstückig mit dem Spanschutzrahmen 5 ausgebildet. Es kann aber muss nicht vorgesehen sein, jede Kontaktkammer 6 fluidisch von den benachbarten Kontaktkammern zu trennen. Beim Verguss der Leiterplatte 2 kann die Vergussmasse 8 beispielsweise durch nicht dargestellte verschließbare Öffnungen in den Bereich innerhalb des Spanschutzrahmens 5 eindringen und in direkten Kontakt mit dem Kontaktelementen 4 gelangen. Die Kontaktelemente 4 werden hier durch kompakte Metallsockel gebildet, die hohe Ströme leiten können und von der Vergussmasse 8 seitlich direkt umfasst werden, beziehungswiese flankiert werden. Auch hier ragt ein zweiter Endabschnitt 42 der Kontaktelemente 4 aus der Vergussmasse 8 heraus, der jeweils in einer Kontaktkammer 6 angeordnet ist. Die Gegenkontakte 33 können mittels der verstellbaren Einstellmitteln 36 gegen die zweiten Endabschnitte 42 der Kontaktelemente 4 angedrückt werden.

## Patentansprüche

1. Elektrische Baugruppe (1), insbesondere für ein Kraftfahrzeuggetriebe, umfassend:
- eine Leiterplatte (2) mit wenigstens einer Bestückungsseite (21),
- wenigstens zwei auf der Bestückungsseite (21) angeordnete Kontaktflächen (23),
- wenigstens zwei Kontaktelemente (4), die jeweils mit einem leiterplattenseitigen ersten Endabschnitt (41) mit einer der Kontaktflächen (23) elektrisch verbunden sind,
- eine auf der Bestückungsseite (21) der Leiterplatte (2) angeordnete Vergussmasse (8), in welche die Kontaktelemente (4) teilweise eingebettet sind, wobei die Vergussmasse (8) mit den Kontaktflächen (23) und leiterplattenseitigen Endabschnitte (41) der Kontaktelemente (4) in direktem Kontakt steht und diese abdeckt und wobei die Kontaktelemente (4) mit von der Leiterplatte (2) abgewandten zweiten Endabschnitten (42) aus der Vergussmasse (8) hervorstehen,
**dadurch gekennzeichnet, dass** die elektrische Baugruppe (1) einen Spanschutzrahmen (5) umfasst, der mit einem der Leiterplatte (2) zugewandten Abschnitt (51) an der Bestückungsseite (21) der Leiterplatte (2) angeordnet ist und der mit einem von der Leiterplatte (2) abgewandten Abschnitt (52) aus der Vergussmasse (8) nach außen hervorsteht, wobei der aus der Vergussmasse (8) nach außen hervorstehende Abschnitt (52) des Spanschutzrahmens (5) mehrere den Kontaktelementen (4) jeweils zugeordnete, nicht mit Vergussmasse (8) gefüllte Kontaktkammern (6) bildet und in jeder Kontaktkammer (6) jeweils nur ein zweiter Endabschnitt (42) eines Kontaktelementes (4) angeordnet ist.

2. Elektrische Baugruppe nach Anspruch 1, **dadurch gekennzeichnet, dass** die elektrischen Baugruppe (1) weiterhin ein elektrisches Bauelement (3) umfasst, wobei das elektrische Bauelement (3) an einer der Leiterplatte (2) zuweisenden Seite (32) wenigstens zwei Gegenkontakte (33) aufweist, die mit den zweiten Endabschnitten (42) der Kontaktelemente (4) jeweils kontaktiert sind.

3. Elektrische Baugruppe nach Anspruch 2, **dadurch gekennzeichnet, dass** das elektrische Bauelement (3) in den aus der Vergussmasse (8) nach außen hervorstehenden Abschnitt (52) des Spanschutzrahmens (5) eingreift.

4. Elektrische Baugruppe nach Anspruch 2 oder 3, **dadurch gekennzeichnet, dass** das elektrische Bauelement (3) an seiner der Leiterplatte (2) zuweisenden Seite (32) eine Schutzgeometrie (37) aus vorspringenden Wänden (34) und/oder eingelassenen Nuten (35) aufweist.

5. Elektrische Baugruppe nach Anspruch 4, **dadurch gekennzeichnet, dass** die Schutzgeometrie (37) mit dem aus der Vergussmasse (8) nach außen hervorstehenden Abschnitt (52) des Spanschutzrahmens (5) derart in einem labyrinthartigen Eingriff steht, dass die Kontaktkammern (6) fluidisch verbindende Zwischenräume zwischen der Schutzgeometrie (37) und dem Spanschutzrahmen (5) U-förmige Umlenkkanäle (7) bilden.

6. Elektrische Baugruppe nach einem der Ansprüche 2 bis 5, **dadurch gekennzeichnet, dass** das elektrische Bauelement (3) ein Sensorbauelement (38) ist.

7. Elektrische Baugruppe nach Anspruch 2, **dadurch gekennzeichnet, dass** das elektrische Bauelement (3) einstückig mit dem Spanschutzrahmen (5) ausgebildet ist.

8. Elektrische Baugruppe nach Anspruch 7, **dadurch gekennzeichnet, dass** das elektrische Bauelement (3) einen Kontaktschuh (39) mit verstellbaren Einstellmitteln (36), an denen die Gegenkontakte (33) ausgebildet sind, aufweist.

9. Elektrische Baugruppe nach einem der vorstehenden Ansprüche , **dadurch gekennzeichnet, dass** der Spanschutzrahmen (5) aus Kunststoff, aus Metall oder aus einem Kunststoff-Metall-Verbund hergestellt ist.

10. Elektrische Baugruppe nach einem der vorstehenden Ansprüche, **dadurch gekennzeichnet, dass** die elektrische Braugruppe (1) Teil eines elektronischen Getriebesteuermoduls (100) oder Sensormoduls (101) eine Kraftfahrzeuggetriebes ist.

## Claims

1. Electrical assembly (1), in particular for a motor vehicle transmission, comprising:
- a printed circuit board (2) that has at least one component side (21),
- at least two contact surfaces (23) arranged on the component side (21),
- at least two contact elements (4), which are respectively electrically connected, by a first end portion (41) on the printed circuit board side, to one of the contact surfaces (23),
- a potting compound (8), arranged on the component side (21) of the printed circuit board (2), in which the contact elements (4) are partly embedded, wherein the potting compound (8) is in direct contact with and covers the contact surfaces (23) and end portions (41) of the contact elements (4) on the printed circuit board side, and wherein the contact elements (4) protrude, by second end portions (42) that face away from the printed circuit board (2), from the potting compound (8),
**characterized in that** the electrical assembly (1) comprises a chip protection frame (5) that, by a portion (51) that faces toward the printed circuit board (2), is arranged on the component side (21) of the printed circuit board (2) and that, by a portion (52) that faces away from the printed circuit board (2), protrudes outward from the potting compound (8), wherein the portion (52) of the chip protection frame (5) that protrudes outward from the potting compound (8) forms a plurality of contact chambers (6), not filled with potting compound (8), that are respectively assigned to the contact elements (4), and respectively only one second end portion (42) of a contact element (4) is arranged in each contact chamber (6).

2. Electrical assembly according to Claim 1, **characterized in that** the electrical assembly (1) additionally comprises an electrical component (3), wherein, on a side (32) that faces toward the printed circuit board (2), the electrical component (3) has at least two counter-contacts (33), which are respectively contacted to the second end portions (42) of the contact elements (4).

3. Electrical assembly according to Claim 2, **characterized in that** the electrical component (3) engages in the portion (52) of the chip protection frame (5) that protrudes outward from the potting compound (8).

4. Electrical assembly according to Claim 2 or 3, **characterized in that**, on its side (32) that faces toward the printed circuit board (2), the electrical component (3) has a protective geometry (37) composed of projecting walls (34) and/or recessed slots (35).

5. Electrical assembly according to Claim 4, **characterized in that** the protective geometry (37) is in a labyrinth-type engagement with the portion (52) of the chip protection frame (5) that protrudes outward from the potting compound (8), in such a manner that spaces, between the protective geometry (37) and the chip protection frame (5), that fluidically connect the contact chambers (6) form U-shaped deflection channels (7) .

6. Electrical assembly according to any one of Claims 2 to 5, **characterized in that** the electrical component (3) is a sensor component (38).

7. Electrical assembly according to Claim 2, **characterized in that** the electrical component (3) is integral with the chip protection frame (5).

8. Electrical assembly according to Claim 7, **characterized in that** the electrical component (3) has a contact shoe (39) having adjustable setting means (36), on which the counter-contacts (33) are realized.

9. Electrical assembly according to any one of the preceding claims, **characterized in that** the chip protection frame (5) is produced from plastic, from metal or from a plastic-metal composite.

10. Electrical assembly according to any one of the preceding claims, **characterized in that** the electrical assembly (1) is part of an electronic transmission control module (100) or sensor module (101) of a motor vehicle transmission.

## Revendications

1. Ensemble électrique (1) destiné notamment à une transmission de véhicule automobile et comprenant :
- une carte de circuit imprimé (2) pourvu d'au moins un côté composants (21),
- au moins deux surfaces de contact (23) disposées du côté composants (21),
- au moins deux éléments de contact (4) qui sont chacun reliés électriquement à l'une des surfaces de contact (23) par une première portion d'extrémité côté circuit imprimé (41),
- un composé d'enrobage (8) qui est disposé du côté composants (21) de la carte de circuit imprimé (2) et dans lequel les éléments de contact (4) sont partiellement noyés, le composé d'enrobage (8) étant en contact direct avec les surfaces de contact (23) et les portions d'extrémité côté carte de circuit imprimé (41) des éléments de contact (4) et recouvrant ceux-ci et les deuxièmes portions d'extrémité (42), opposées à la carte de circuit imprimé (2), des éléments de contact (4) faisant saillie du composé d'enrobage (8), **caractérisé en ce que** l'ensemble électrique (1) comprend un cadre de protection contre les copeaux (5) dont une portion (51), dirigée vers la carte de circuit imprimé (2), est disposée du côté composant (21) de la carte de circuit imprimé (2) et dont une portion (52) opposée à la carte de circuit imprimé (2) fait saillie du composé d'enrobage (8) vers l'extérieur, la portion (52) du cadre de protection contre les copeaux (5), qui fait saillie du composé d'enrobage (8) vers l'extérieur, formant une pluralité de chambres de contact (6) associées respectivement aux éléments de contact (4) et non remplies de composé d'enrobage (8) et seule une deuxième portion d'extrémité (42) d'un élément de contact (4) est disposée dans chaque chambre de contact (6).

2. Ensemble électrique selon la revendication 1, **caractérisé en ce que** l'ensemble électrique (1) comprend en outre un composant électrique (3), le composant électrique (3) comportant, sur un côté (32) dirigé vers la carte de circuit imprimé (2), au moins deux contacts homologues (33), qui sont chacun en contact avec les deuxièmes portions d'extrémité (42) des éléments de contact (4).

3. Ensemble électrique selon la revendication 2, **caractérisé en ce que** le composant électrique (3) s'engage dans la portion (52) du cadre de protection contre les copeaux (5) qui fait saillie du composé d'enrobage (8) vers l'extérieur.

4. Ensemble électrique selon la revendication 2 ou 3, **caractérisé en ce que** le composant électrique (3) présente sur son côté (32) dirigé vers la carte de circuit imprimé (2) une géométrie de protection (37) comprenant des parois en saillie (34) et/ou des rainures en retrait (35).

5. Ensemble électrique selon la revendication 4, **caractérisé en ce que** la géométrie de protection (37) étant en engagement labyrinthique avec la portion (52) du cadre de protection contre les copeaux (5) qui fait saillie du composé d'enrobage (8) vers l'extérieur de manière à ce que des espaces intermédiaires, reliant fluidiquement les chambres de contact (6), forment des canaux de déviation (7) en forme de U entre la géométrie de protection (37) et le cadre de protection contre les copeaux (5).

6. Ensemble électrique selon l'une des revendications 2 à 5, **caractérisé en ce que** le composant électrique (3) est un composant capteur (38).

7. Ensemble électrique selon la revendication 2, **caractérisé en ce que** le composant électrique (3) est formé d'une seule pièce avec le cadre de protection contre les copeaux (5).

8. Ensemble électrique selon la revendication 7, **caractérisé en ce que** le composant électrique (3) comporte un patin de contact (39) pourvu de moyens de réglage déplaçables (36) sur lesquels sont formés les contacts homologue (33).

9. Ensemble électrique selon l'une des revendications précédentes, **caractérisé en ce que** le cadre de protection contre les copeaux (5) est en matière synthétique, en métal ou en un composite métal-matière synthétique.

10. Ensemble électrique selon l'une des revendications précédentes, **caractérisé en ce que** l'ensemble électrique (1) fait partie d'un module de commande de transmission électronique (100) ou module capteur (101) d'une transmission de véhicule automobile.
